# EUROPEAN PATENT APPLICATION

(11) **EP 1 798 851 A1**
(43) Date of publication of application: **20.06.2007**
(21) Application number: 05292684.7
(22) Date of filing: 14.12.2005
(51) Int. Cl.: H03D 7/14

(54) **Enhanced mixer device**

(71) Applicant: Dibcom, 91120 Palaiseau (FR)
(72) Inventor: Jönsson, Jonas, 17458 Sundbyberg (SE)
(74) Representative: Cefai, Robin

(57) **Abstract**

This device (12, 14) for mixing radiofrequency signals (RF) comprises:
- a mixer circuit (18, 20) adapted to mix at least two signals, one of which is a radiofrequency signal; and
- a current mirror circuit (22, 24) receiving signals delivered by the mixer circuit and delivering output signals.

It is characterized in that said current mirror circuit (18, 20) is also adapted to perform low pass filtering of the signals going through it.

## Description

The present invention concerns signals mixers using current mirrors, and receivers for radiofrequency signals using such mixers.

It is conventional to use signal mixer devices comprising an output current. For example, in radiofrequency receivers the received signal is mixed after amplification with the signal of a local oscillator to perform a frequency change and deliver an intermediate frequency signal or a base band signal. The mixed signal is fed into a current mirror circuit to ensure the value of the output current regardless of the impedance at the output of the mixer device. Accordingly, the output current is determined by the input current regardless of the output impedance.

The output of such a mixer is conventionally filtered before the signals are converted into digital signals which are used for demodulation.

However, the constraints on the linearity of the mixer, of the converters and of a downstream base band stage, are high. More precisely, the signal still has energy spread over a wide range of frequency which must be taken into account when designing these circuits to avoid saturation and other perturbations.

Accordingly, the mixer devices and the corresponding receivers are designed with constraints due to unwanted signals which leads to sub-optimal designs and sub-optimal performances.

The aim of the present invention is to solve this problem by providing an enhanced device for mixing radiofrequency signals. To this effect the invention provides a mixer device as recited in claim 1 and a corresponding receiver as recited in claim 9.

Thanks to the integration of low pass filters in the current mirror stage, the spread of the frequency spectrum of the signal is reduced. Thus the unwanted signals are rejected at an early stage of signal processing, relaxing the constraints on the circuits.

Other features and advantages of the invention will be apparent from the description illustrated by the drawings in which:
- figure 1, represents a receiver comprising a mixer device with a current mirror stage;
- figure 2 represents the detailed circuit of a mixer device according to the invention;
- figures 3, 4, 5 and 6 represent other embodiments of the invention.

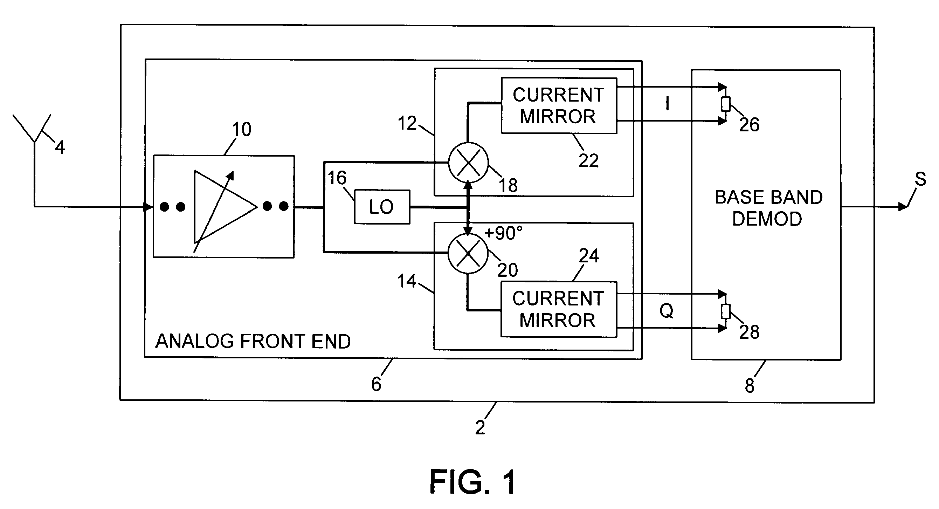

In figure 1, is represented a receiver 2 adapted to receive through an antenna 4, radio frequency (RF) signals, like digital television signals using the MPEG-2 format in a DVB-H or DVB-T transmission.

The antenna 4 is connected to an analog front end 6 which output is fed into a base band demodulator 8 applying the relevant demodulation or equalization processing to derive an information signal S supplied to other processing circuits, with which the receiver 2 is associated.

Along with other components, the analog front 6 comprises an amplifier stage 10 with one or several low noise amplifiers (LNA). The output of the amplifier stage 10 is fed into two mixer devices 12 and 14. Each mixer device also receives a signal delivered by a local oscillator 16. The signal fed into the mixer device 14 has a phase shift of 90° with regard to the signal provided to the mixer device 12.

Each mixer device 12 and 14 comprises a mixer circuit, identified respectively 18 and 20, to mix the radiofrequency signal provided by the amplifier stage 10 with the signal provided by the local oscillator 16. Each of the outputs of these mixer circuits 18 and 20 are fed into a mirror current circuit 22 and 24.

The mirror current circuits 22 and 24 respectively deliver the real component of the signal identified by I, and the imaginary component of the signal, identified by the letter Q.

In the embodiments described, all the signals from the amplifier stage 10 down to the base band demodulator 8 are balanced signals accordingly the output signals of the current mirror circuits are balanced signals delivered through impedances 26 and 28.

In the example described, the impedances 26 and 28 are the impedances of the processing circuits of the base band demodulator 8.

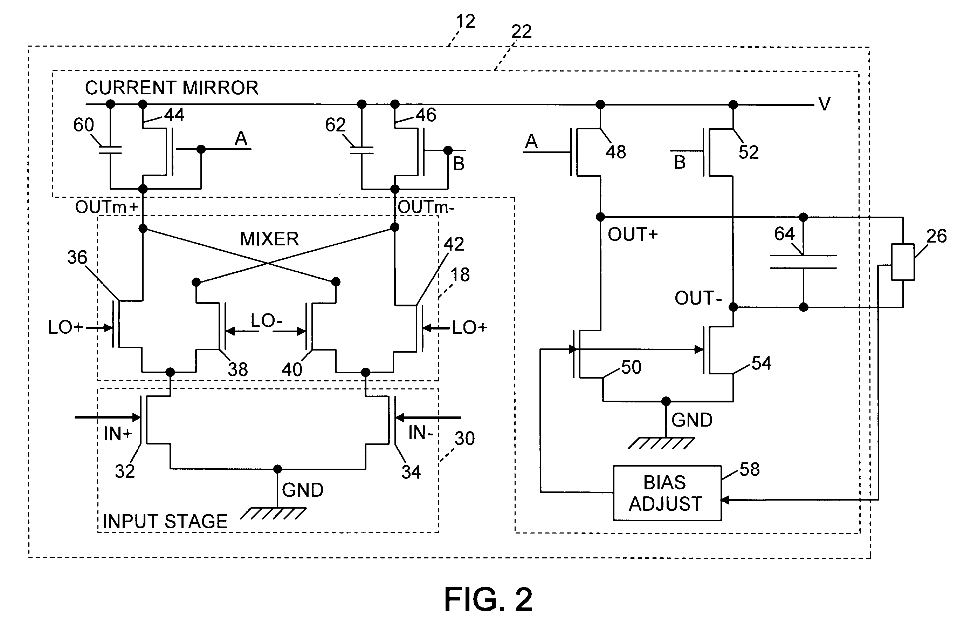

In figure 2 is represented the detailed circuit of the mixer device 12 comprising an input stage 30 connected to the mixer circuit 18 and the mirror current circuit 22.

The input stage 30 comprises two transistors 32, 34 mounted in parallel, each being connected to the ground and provided on their gate terminals with the radiofrequency signal as delivered by the amplifier stage 10. These inputs are balanced and are respectively referred to as the negative and positive inputs IN+ and IN-.

Of course, other kind of conventional input stages using for example cascode connected transistor can be used.

The general function of the input stage is to transform a voltage, namely the voltage between inputs IN+ and IN-, into a current fed into the mixer circuits.

The outputs of the input stage transistors 32, 34 are fed into the mixer circuit and more precisely, each signal is fed into a pair of second stage transistors, namely 36, 38 and 40, 42, the drain terminals of each pair being connected together.

The symmetrical mixer transistors 36 and 42 are each fed on their gate terminals with the signal provided by the local oscillator 16 and their outputs are the outputs of the mixer circuit.

Furthermore, each of these outputs is also connected to the output of the other mixer transistor of the other pair. Thus, the output of transistor 36 is connected to the output of transistor 40 and reciprocally, the output of transistor 42 is connected to the output of transistor 38.

Finally, the gate terminals of the two symmetrical transistors 38 and 40 are connected together.

Such a mixer circuit is conventional and will not be described in further details.

The outputs of the mixer circuit 18, namely the positive and negative outputs OUTm⁺ and OUTm⁻, are fed into the current mirror circuit 22 and more precisely into a first stage of the current mirror circuit. This first stage of the mirror current circuit comprises two transistors 44 and 46 whose drain terminals are connected respectively to the outputs OUTm⁺ and OUTm⁻ of the mixer circuit and whose source terminals are connected to a direct voltage source V, alternatively trough a series connected resistor. The gate terminals of these transistors are connected to the respective outputs of the mixer circuit and the signal at these gate terminals are named A and B and fed into a second stage of the current mirror circuit.

This second stage comprises two pairs of transistors, namely 48, 50 and 52, 54, the transistors of one pair being series connected between the direct voltage source V and a ground GND. Each of the transistors of said pairs connected to the direct voltage source receives on its gate terminal respectively the signal A or B as delivered by the transistors of the first stage.

The outputs of the current mirror circuit are formed by the signals taken between the central points of each of the two pairs of transistors, namely the positive output OUT+ between the transistors 48 and 50 on one side and the negative output OUT- between the transistors 50 and 52 on the other side.

The impedance 26 representing the impedance of the processing circuits of the base band demodulator 8 is connected between the two outputs OUT + and OUT- and accordingly, receives the signal I.

The second transistors 50 and 54 of each pair of said second stage transistors are designed to have high impedances so that the current signal goes into the base band demodulator 8 to minimize the gain loss.

The gates terminals of transistors 50 and 54 are fed with a bias signal delivered by a bias adjustment circuit 58 connected in a conventional manner to a control point of the impedance 26.

Furthermore, the current mirror circuit 22 is also adapted to perform low pass filtering of the signal delivered by the mixer circuit. This filtering is performed simultaneously with the conventional function of the current mirror circuit, namely providing an output current determined by the input current regardless of the output impedance.

In the example described, each of the first and second stages of the circuit mirror current comprises a low pass filter using capacitors connected to the transistors of the first and second stages.

In the first stage, filtering capacitors 60, 62 are connected in parallel with each of the two transistors 44 and 46, i.e. between the direct voltage source V and each of the outputs OUTm⁺ and OUTm⁻ of the mixer circuit. In the example, the cut-off frequency of each of these filters is about 14MHz.

In the second stage, a filtering capacitor 64 is connected between the drain terminals of each of the transistors 48 and 52, i.e. between the central points of each of the two pairs of transistors. This capacitor also attenuates the unwanted signal, and as the respective impedance of each of the two stages are independent, the cut-off frequency of this capacitor 64 can be different from the one of the first stage and especially can be smaller. In the example, the cut-off frequency of the capacitor 64 is about 8 MHz.

Thus, the mixer of the invention delivers a signal which current is determined by the input current regardless of the output impedance and simultaneously filtered. Accordingly, the swing of the signal is smaller and thus, the impedance of the down stream stages can be higher and the linearity constraint is reduced. More precisely, requirements on the current mirror circuit, base band circuits and analog to digital converters are relaxed. Furthermore, due to the reduced linearity constraint, the overall current consumption of the device is reduced by use of components with lower linearity specifications.

Other embodiments of the invention are also possible, especially by using various circuits to connect the filtering capacitors.

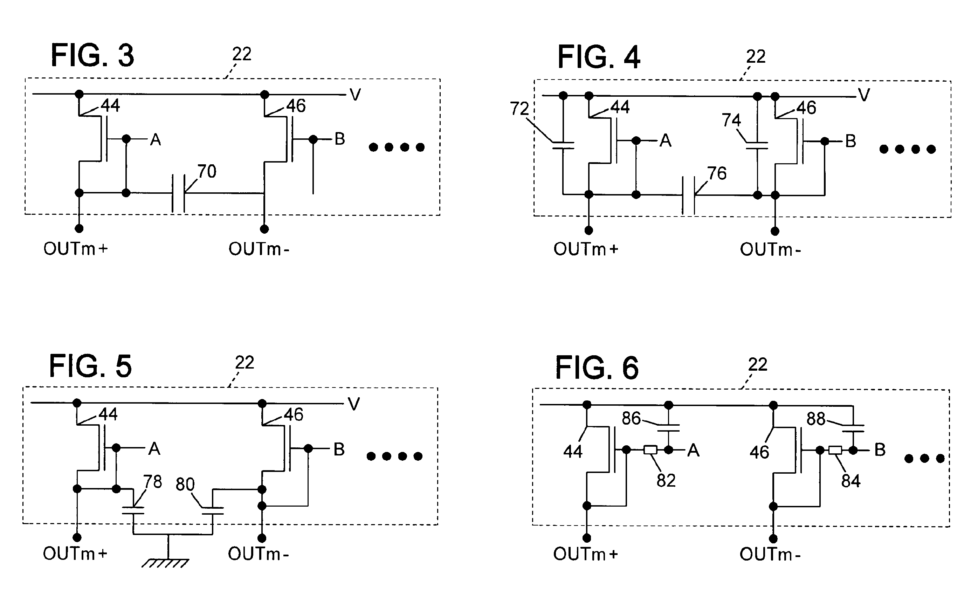

In another embodiment represented with reference to figure 3, one single filtering capacitor 70 is used in the first stage in a similar manner to the circuitry of the second stage as described with reference to figure 2. This capacitor 70 is connected between the drain terminals of the first stage transistors 44 and 46, i.e. between the outputs of the mixer circuit OUTm⁺ and OUTm⁻.

Alternatively, the two embodiments described previously are combined as represented in figure 4. In this example the combination is applied to the first stage and filtering capacitors 72 and 74 are connected in parallel with each of the transistors 44 and 46 and another capacitor 76 is connected between the outputs of the mixer circuit.

Yet in another embodiment represented with reference to figure 5, filtering capacitors 78, 80 are connected in the first stage of the current mirror circuit 22 between the drain terminals of the transistors and the ground.

Any of these various circuits, namely, the use of capacitors connected in parallel with each transistor, the use of a single capacitor connected between the drain terminals, the combination of these two circuits as well as the use of capacitors connected to the ground, can also be used in the second stage.

Alternatively, each of the gate terminals of the first stage transistors is series-connected with a resistor 82, 84 whose outputs represent respectively the A and B signals. In this embodiment, filtering capacitors 86, 88 are connected between the direct voltage source and the output of the resistors 82 and 84, as represented in figure 6.

All these embodiments will perform similar filtering of the signal and can be combined with a second stage filter as described previously.

Furthermore, it is possible to use a non-balanced circuit having a single input and in which the input stage, the mixer circuit and the current mirror circuit are adapted in a conventional manner.

Furthermore, any of the filtering capacitors, namely capacitors 60, 62, 64, 70, 76, 78, 80, 86, 88 can be made adjustable to attenuate different unwanted frequencies

## Claims

1. Device (12, 14) for mixing radiofrequency signals (RF) comprising:
- a mixer circuit (18, 20) adapted to mix at least two signals, one of which is a radiofrequency signal; and
- a current mirror circuit (22, 24) receiving signals delivered by the mixer circuit and delivering output signals,
**characterized in that** said current mirror circuit (22, 24) is also adapted to perform low pass filtering of the signals going through it.

2. Device according to claim 1, wherein said current mirror circuit comprises a first stage connected to outputs (OUTm⁺, OUTm⁻) of the mixer circuit and a second stage connected to the output (OUT+, OUT-) of the device, each of said first and second stages comprising a respective low pass filter.

3. Device according to claim 2, wherein said first stage comprises transistors (44, 46) each connected between a respective one of the outputs of the mixer circuit (OUTm⁺, OUTm⁻) and a direct voltage source (V) and said second stage comprises transistors (48, 52) each connected between said direct voltage source and a respective one of the outputs of the device and wherein the device further comprises filtering capacitors (60, 62, 64; 70; 72, 74, 76; 86, 88) respectively connected with said first and second stage transistors.

4. Device according to claim 3, wherein filtering capacitors (60, 62; 72, 74) are connected in parallel with each transistor (44, 46) of at least one of said first and second stages.

5. Device according to any one of claims 3 and 4, wherein a filtering capacitor (64; 70) is connected between the drain terminals of the transistors of at least one of said first and second stages.

6. Device according to any one of claims 3 to 5, wherein filtering capacitors (78, 80) are connected between a ground (GND) and a drain terminal of each transistor of at least one of said first and second stages.

7. Device according to any one of claims 3 to 6, wherein gate terminals of each transistor of said first stage are being series-connected to an impedance (82, 84), and wherein the device further comprises a filtering capacitor (86, 88) connected between said direct voltage source and the output of each of said impedances.

8. Device according to any one of claims 2 to 7, wherein said second stage comprises pairs of transistors (48, 50, 52, 54) series-connected between a direct voltage source (V) and a ground and wherein the outputs of the device are formed by the central points of each one of said pairs of transistors of said second stage.

9. Receiver for radiofrequency signals comprising an analog front end (6) comprising at least one mixing device which is connected to a base band stage (8), wherein said mixing device is a mixing device according to any one of claims 1 to 8.
